(19) Europäisches Patentamt
European Patent Office
Office européen des brevets

(11) Veröffentlichungsnummer: **0 002 659**
**B1**

(12) # EUROPÄISCHE PATENTSCHRIFT

(45) Veröffentlichungstag der Patentschrift: **01.04.81**

(51) Int. Cl.³: **G 01 R 15/07**, G 02 F 1/09

(21) Anmeldenummer: **78101077.2**

(22) Anmeldetag: **05.10.78**

(54) **Verfahren zur magnetooptischen Strommessung.**

(30) Priorität: **29.12.77 DE 2758723**

(43) Veröffentlichungstag der Anmeldung:
**11.07.79 Patentblatt 79/14**

(45) Bekanntmachung des Hinweises auf die Patenterteilung:
**01.04.81 Patentblatt 81/13**

(84) Benannte Vertragsstaaten:
**CH DE FR GB**

(56) Entgegenhaltungen:
**DE - A - 1 766 957**
**DE - A - 2 043 517**
**US - A - 3 740 151**

**ZEITSCHRIFT ANALYTISCHE CHEMIE, Band 263, Heft 3, 1973, J. WINKER "Geräte zur Messung der magnetooptischen Aktivität. II. Der Magneto-Circulardichroismus" Seiten 177 bis 183**

(73) Patentinhaber: **SIEMENS AKTIENGESELLSCHAFT**
**Berlin und München**
**Postfach 22 02 61**
***D-8000 München 22 (DE)***

(72) Erfinder: **Papp, Alfred, Dr.**
**Winternitzstrasse 6**
**D-8000 München (DE)**
Erfinder: **Harms, Hauke**
**Annette-Kolb-Anger 11**
**D-8000 München (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 002 659 B1

# Verfahren zur magnetooptischen Strommessung

Die Erfindung bezieht sich auf ein Verfahren zur magnetooptischen Strommessung mit einem linear polarisierten Lichtstrahl, dessen Polarisationsebene in Abhängigkeit vom Strom gedreht wird, wobei dem Meßsignal ein weiteres Signal überlagert wird.

Es sind Meßeinrichtungen für Ströme in Hochspannungsleitern und für große Wechselströme mit Gleichstromglied bekannt, bei denen ein Lichtstrahl über einen Polarisator, einen magnetooptischen Meßfühler sowie einen Analysator einem Detektor zugeführt wird, dem eine Elektronik nachgeschaltet ist. Die Polarisationsebene des Lichtstrahls wird in dem vom magnetischen Feld des zu messenden Stromes beeinflußten Meßfühler entsprechend der Größe des Stromes gedreht. In einer auf Niederspannungspotential angeordneten Auswerteeinrichtung wird im Analysator die Größe der Drehung in ein entsprechendes Intensitätssignal umgewandelt, das vom Fotodetektor erfaßt werden kann. Das Ausgangssignal des Detektors wird in der Elektronik verarbeitet.

In einer bekannten Anordnung (deutsche Patentschrift 2 130 047) enthält die Auswerteeinrichtung einen Analysator, in dem das vom Meßfühler kommende polarisierte Licht, vorzugsweise ein Laserstrahl, in zwei Teillichtstrahlen aufgespalten wird, deren Polarisationsebenen senkrecht aufeinander stehen und die ihre Intensität mit dem Drehwinkel der Polarisationsebene des einfallenden Strahles gegenläufig ändern. Die beiden Teillichtstrahlen werden jeweils einem Detektor, vorzugsweise einer Halbleiterfotodiode, zugeführt, denen ein Differenzverstärker nachgeschaltet ist. Die Differenzspannung dient als Maß für die Faraday-Drehung des Meßsignals. Mit diesem Differential-Verfahren können zwar Rauschanteile des Meßsignals eliminiert werden, die durch Intensitätsschwankungen des Lichtstrahls verursacht werden. In einem technischen Aufbau ist es aber unvermeidlich, daß die Laserstrahlen auf den Halbleiterfotodioden örtlich schwanken. Da die Fotoempfindlichkeit dieser Dioden ortsabhängig ist, können Strahlverlagerungen von wenigen µm Signalschwankungen bis zu mehreren Prozent verursachen. Außerdem zeigen solche Fotodioden eine geringe Exemplarstreuung ihrer Empfindlichkeit. Die den beiden Teilstrahlen zugeordneten Detektoren liefern somit unterschiedliche Signalschwankungen, die mit diesem Verfahren nicht eliminiert werden können.

Ein weiteres bekanntes Verfahren (Rogers in "Optical Methods for Measurement of Voltage and Current at High Voltage", A.I.M. Liege, Traitment des donnees-1977, Seite 6, Abschnitt 3.2 (c) Intensity Distribution Noise) arbeitet deshalb mit einem modulierten Lichtstrahl, der über den Meßfühler und einen Analysator einer einzigen Fotodiode zugeführt wird, deren Ausgangssignal in einer Elektronik verarbeitet wird. Der Detektor erfaßt die Intensität des ankommenden Meßsignals, das noch das überlagerte Modulationssignal enthält. Die Demodulation erfolgt in der nachgeschalteten Elektronik. Die Intensität wird sowohl durch die Faraday-Drehung im Meßfühler als auch durch die erwähnten Rauschanteile beeinflußt. Mit diesem Meßverfahren können beide Intensitätskomponenten voneinander getrennt werden und der Rauschanteil am Meßsignal wird unterdrückt. Die Linearität zwischen Nutz- und Meßsignal ist aber nur bei kleinen Drehwinkeln bis zu etwa 2° ausreichend. Bei größeren Drehwinkeln mit entsprechend größerem Signal-Rauschverhältnis macht sich eine von der Signalamplitude abhängige Nichtlinearität bemerkbar.

Der Erfindung liegt nun die Aufgabe zugrunde, das eingangs genannte Verfahren so zu verbessern, daß ihm nur ein kleiner Meßfehler von beispielsweise weniger als 0,2% bei einer wesentlich größeren Drehung der Polarisationsebene als oben erwähnt zu eigen ist.

Diese Aufgabe wird bei einem Verfahren der eingangs genannten Art erfindungsgemäß dadurch gelöst, daß die Polarisationsrichtung des Lichtstrahls zusätzlich zur Modulation durch den zu messenden Strom mit der Frequenz des weiteren Signals zwischen zwei senkrecht aufeinanderstehenden Richtungen (P1, P2) hin- und hergeschaltet wird und daß die aus der gesamten Polarisationsmodulation des Lichtstrahls nach Durchlaufen desselben durch einen Analysator entstehenden, den genannten Polarisationsrichtungen (P1, P2) zugeordneten Intensitätssignale ($D_+$, $D_-$) mit der Frequenz ($f_m$) des weiteren Signals abwechselnd getrennten elektronischen Kanälen zugeleitet und schließlich gleichzeitig verarbeitet werden. Die Frequenze des weiteren Signals, vorzugsweise eines Rechtecksignals, soll mindestens eine, vorzugsweise wenigstens zwei Größenordnungen höher als die Frequenz des Meßsignals sein. Die Polarisationsrichtung wird mit der Frequenz des weiteren Signals zwischen den beiden senkrecht zueinander stehenden Polarisationsrichtungen, die in bezug auf die Durchlaßrichtung des Analysators vorzugsweise jeweils einen positiven bzw. negativen Winkel von 45° einschließen, hin- und hergeschaltet. Vorzugsweise werden die den beiden Polarisationszuständen zusammen mit dem Faraday-Drehmeßsignal zugehörenden Lichtintensitäten nach dem Analysator zeitlich nacheinander von einem Detektor erfaßt und in einer nachgeschalteten Elektronik gleichzeitig verarbeitet. Da die Frequenz des weiteren Signals wesentlich höher sein soll als die Signalfrequenz, d.h. die Frequenz des zu messenden Stromes, die im allgemeinen 50 Hz beträgt, und als die Frequenzen der Rauschanteile, kann das Meßsignal elektronisch mit genügender Genauigkeit reproduziert und zugleich der Rauschanteil am Meßsignal eliminiert werden. Diese Eliminierung erfolgt vorzugsweise dadurch, daß der Quotient aus der Differenz und der Summe der Detektorsignale für zeitlich aufeinander folgende Polarisationszustände gebildet wird.

Das weitere Signal dient bei diesem Verfahren nur zur Herstellung der Polarisationszustände im

Modulator. Es tritt für die Elektronik nicht in Erscheinung und es erfolgt dementsprechend in der Elektronik auch keine Demodulation dieses Signals.

Zur weiteren Erläuternung der Erfindung wird auf die Zeichnung Bezug genommen, in deren Fig. 1 ein Ausführungsbeispiel einer Anordnung zur Durchführung des Verfahrens nach der Erfindung schematisch veranschaulicht ist. Fig. 2 zeigt die Zuordnung der beiden Polarisationsrichtungen zum Analysator. In Fig. 3 ist eine mögliche Ausführungsform der Verarbeitungse Elektronik dargestellt.

In Fig. 1 ist eine Strahlungsquelle mit 2, ein Modulator mit 4, ein Meßfühler mit 6, ein Analysator mit 8 und ein Detektor mit 10 bezeichnet. Dem Detektor 10 ist eine Elektronik 12 nachgeschaltet. Ferner ist ein Modulationstreiber 14 für den Umschalt-Modulator 4 und die Elektronik 12 vorgesehen. Die Strahlungsquelle 2 liefert einen nicht näher bezeichneten Strahl polarisierten Lichts, vorzugsweise einen Laserstrahl, dessen Polarisationsrichtung im Umschalt-Modulator 4 mit hoher Frequenz $f_m$, die bei einem Meßsignal von 50 Hz vorzugsweise etwa 10 kHz bis 100 kHz, insbesondere etwa 50 kHz beträgt, zwischen zwei Polarisationsrichtungen, die einen Winkel von 90° einschließen, hin und hergedreht wird.

Als Umschalt-Modulator 4 kann vorzugsweise ein elektrooptischer Modulator vorgesehen sein, der einen elektrooptischen Kristall mit Doppelbrechung enthält, die durch Anlegen einer Spannung verändert werden kann. Die zu Umschaltung erforderlichen Steuerspannungen werden vom dem Modulatortreiber 14 geliefert, der mit der gleichen Frequenz auch die Elektronik 12 steuert und dort die Umschaltung des Ausgangssignals des Detektors 10 auf zwei getrennte Kanäle mit dieser Umschaltfrequenz bewirkt.

Unter Umständen kann beispielsweise auch ein magnetooptischer Modulator zur drehung der Polarisationsrichtung vorgesehen sein. Zur Polarisierung des Lichtstrahls kann dem Umschalt-Modulator 4 auch ein in der Figur nicht dargestellter Polarisator vorgeschaltet sein, falls die Strahlungsquelle 2 kein linear polarisiertes Licht liefert.

Der Meßfühler 6 dreht die Polarisationsrichtung zusätzlich in Abhängigkeit von der Größe eines Magnetfeldes, das einen in der Figur nicht dargestellten elektrischen Leiter umgibt, dessen Strom gemessen werden soll. Der Analysator 8 wandelt die Polarisationsänderung in eine entsprechende Intensitätsänderung um, die von dem nachgeschalteten Detektor 10 erfaßt wird, der vorzugsweise eine Halbleiterdiode oder beispielsweise auch ein Photomultiplier sein kann. Vom Detektor 10 wird ein der Intensität der empfangenen Strahlung entsprechendes elektrisches Signal D abgegeben.

Mit einem Winkel $\alpha$ zwischen der Polarisationsrichtung des Lichtstrahls vor dem Messfühler und der Durchlaßrichtung des Analysators 8 beträgt das Detektorsignal

$$D = p(t) \cdot I(t) \cos^2 [\alpha + F(t)]$$

mit p(t) als Photodiodenempfindlichkeit, I(t) als Intensität des Lichtstrahls und F(t) als Faradaydrehmeßsignal. Um $\alpha = \pm 45°$ ist der Zusammenhang zwischen dem Detektorsignal D und Faradaydrehmeßsignal F(t) praktisch linear. Bei diesen Winkelstellungen zwischen Polarisator und Analysator hat das Meßsystem somit seine größte Empfindlichkeit. Dann gilt für

$$\alpha = +45°: D_- = \frac{p(t) \cdot I(t)}{2} [1 - \sin 2 F(t)]$$

und für

$$\alpha = -45°: D_V = \frac{p(t) \cdot I(t)}{2} [1 + \sin 2 F(t)]$$

Werden nun nach Fig. 2 die zueinander senkrechten Polarisationsrichtungen P1 und P2 am Ausgang des Modulators 4 so gewählt, daß sie mit der Durchlaßrichtung A des Analysators 8 jeweils einen Winkel $+\alpha$ bzw. $-\alpha$ von 45° einschließen und ist die Umschaltfrequenz $f_m$ sehr viel größer sowohl als die Signalfrequenz als auch die Frequenzen der Rauschanteile, so ergibt die Summe

$$D_+ + D_- = p(t) \cdot I(t)$$

den reinen Rauschfaktor des Meßsignals. In der Elektronik 12 werden deshalb die von Detektor 10 jeweils abwechselnd zeitlich nacheinander gelieferten Detektorsignale $D_+$ und $D_-$ im Wechseltakt der von der Steuereinrichtung 14 vorgegebenen Umschaltfrequenz $f_m$ in zwei verschiedene Signalwege geleitet.

Zu diesem Zweck wird nach Fig. 3 beispielsweise das Ausgangssignal des Detektors 10 über einen elektronischen Kippschalter 16, der in der Figur in einfacher Weise als Umschaltontakt dargestellt ist, mit der Frequenz $f_m$ des Umschaltsignals abwechselnd einem elektronischen Speicher 18 bzw. einem elektronischen Rechner 20 zugeführt. Der Kippschalter 16 wird von dem Modulatortreiber 14 mit der Umschaltfrequenz $f_m$ phasengleich gesteuert. Der Speicher 18 speichert beispielsweise nach

dem Prinzip "sample and hold" das der Intensität $D_+$ entsprechende Detektorsignal und gibt es während der folgenden Halbschwingung des Umschaltsignals an den Rechner 20 ab, wenn nach der Umschaltung des Kippschalters 16 dem Rechner 20 das Detektorsignal $D_-$ direkt zugeführt wird.

Anschließend wird im Rechenbaustein 20 der Quotient aus der Differenz und der Summe der Detektorsignale $D_+$ und $D_-$ gebildet und man erhält

$$\frac{D_+ - D_-}{D_+ + D_-} = \sin 2\,F(t)$$

Am Ausgang 22 der Elektronik 12 erhält man somit das Meßsignal sin 2 F(t) ohne Rauschanteil. Es kann beispielsweise mit einem sogenannten "arcussinus"-Baustein linearisiert werden.

Anstelle des Quotienten

$$\frac{D_+ - D_-}{D_+ + D_-}$$

kann in der Elektronik 12 unter Umständen auch der Quotient

$$\frac{D_+}{D_+ + D_-} = 1 + \sin 2\,F(t)$$

oder entsprechend auch

$$\frac{D_-}{D_+ + D_-} = 1 - \sin 2\,F(t)$$

gebildet werden. In diesen Fällen wird der konstante Faktor 1 aus dem Meßsignal elektronisch herausgefiltert.

Das Umschaltsignal hat vorzugsweise eine wenigstens annähernde Rechteckform. Dann bleibt für die Elektronik 12 während der einzelnen Polarisationszustände jeweils eine genügende Zeit für die Messung und Registrierung. Es kann.

**Patentansprüche**

1. Verfahren zur magnetooptischen Strommessung mit einem linear polarisierten Lichtstrahl, dessen Polarisationsebene in Abhängigkeit vom Strom gedreht wird, wobei dem Meßsignal ein weiteres Signal überlagert wird, dadurch gekennzeichnet, daß die Polarisationsrichtung des Lichtstrahls zusätzlich zur Modulation durch den zu messenden Strom mit der Frequenz des weiteren Signals zwischen zwei senkrecht aufeinander stehenden Richtungen (P1, P2) hin- und hergeschaltet wird und daß die aus der gesamten Polarisationsmodulation des Lichtstrahls nach Durchlaufen desselben durch einem Analysator entstehenden, den genannten Polarisationsrichtungen (P1, P2) zugeordneten Intensitätssignale ($D_+$, $D_-$) mit der Frequenz ($f_m$) des weiteren Signals abwechselnd getrennten elektronischen Kanäle zugeleitet und schliesslich gleichzeitig verarbeitet werden.

2. Verfahren nach Anspruch 1, dadurch gekennzeichnet, daß der Rauschanteil des Meßsignals durch Bildung des Quotienten aus der Differenz und der Summe der aufeinander folgenden, den beiden Polarisationsrichtungen zugeordneten Intensitätssignale ($D_+$, $D_-$) eliminiert wird.

**Revendications**

1. Procédé de mesure magnétooptique de courant, mettant en oeuvre unfaisceau lumineux polarisé linéairement, dont le plan de polarisation est pivotée en fonction du courant, cependant qu'au signal de mesure est superposé un autre signal, caractérisé par le fait qu'en plus de la modulation par le courant devant être mesuré, la direction de polarisation du faisceau lumineux est commutée selon un mouvement de va-et-vient entre deux directions (P1, P2) perpendiculaires entre elles, à la fréquence dudit autre signal, et que les signaux d'intensité ($D_+$, $D_-$), formés à partir de l'ensemble de la modulation de polarisation du rayon lumineux après traversée de ce dernier dans un analyseur et associés aux directions indiquées de polarisation (P1, P2), sont envoyés, à la fréquence ($f_m$) dudit autre signal, alternativement à des canaux électroniques séparés et sont enfin traités simultanément.

2. Procédé suivant la revendication 1, caractérisé par le fait que la composante de bruit du signal de mesure est éliminée par formation du quotient entre la différence et la somme des signaux d'intensité ($D_+$, $D_-$) successifs associés aux directions de polarisation.

**Claims**

1. Method for magneto-optical current measurement employing a linearly polarised light beam whose plane of polarisation is rotated in dependence upon the current, wherein a further signal is superimposed upon the measurement signal, characterised in that the polarisation direction of the light beam, in addition to being modulated by the current which is to be measured, is switched to and fro between two directions (P1, P2) at right angles to one another at the frequency of the further signal, and that the intensity signals ($D_+$, $D_-$) which are formed from the overall polarisation modulation of the light beam when the latter has passed through an analyser, and which are assigned to the aforementioned polarisation directions (P1, P2) are alternately fed to separate electronic channels with the frequency ($f_m$ of the further signal, and are finally processed simultaneously.

2. Method as claimed in Claim 1, characterised in that the noise component of the measurement signal is eliminated by forming the quotient of the difference and the sum of the consecutive intensity signals ($D_+$, $D_-$) assigned to the two polarisation directions.

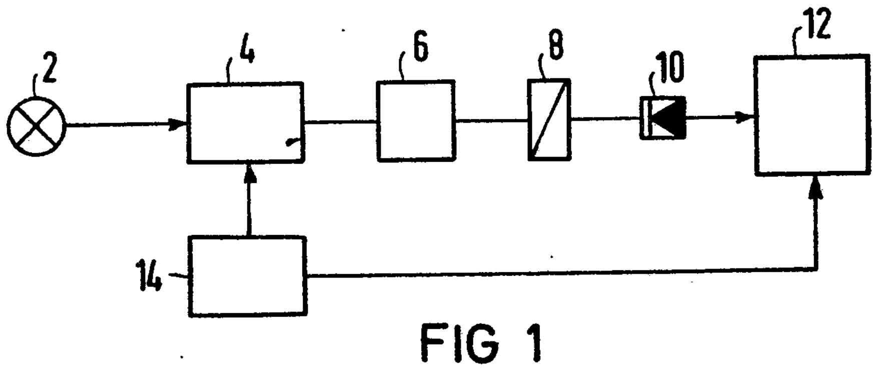


FIG 1

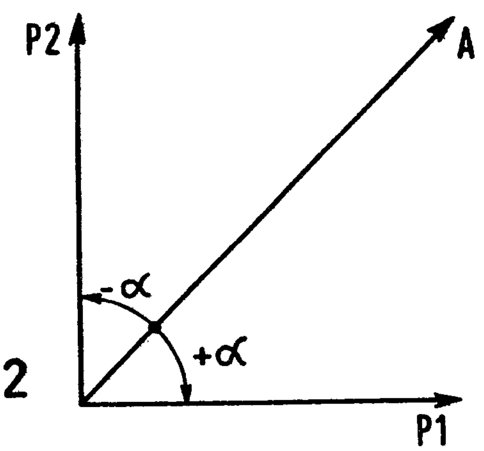


FIG 2

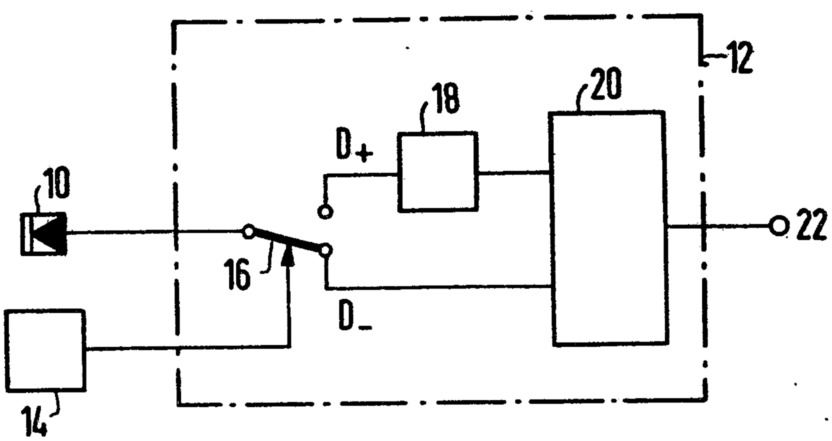


FIG 3